# FASCICULE DE BREVET EUROPEEN

(11) **EP 3 185 422 B1**
(45) Date de publication et mention de la délivrance du brevet: **14.11.2018**
(21) Numéro de dépôt: 16203763.4
(22) Date de dépôt: 13.12.2016
(51) Int. Cl.: H03K 17/14, H02M 1/08

(54) **CIRCUIT DE COMMANDE D'UN TRANSISTOR À GRILLE**
STEUER-SCHALTKREIS FÜR GATE-TRANSISTOR
CONTROL CIRCUIT OF A GATE TRANSISTOR

(30) Priorité: 24.12.2015 FR 1563354
(43) Date de publication de la demande: 28.06.2017
(73) Titulaire: COMMISSARIAT À L'ÉNERGIE ATOMIQUE ET AUX ÉNERGIES ALTERNATIVES, 75015 Paris (FR)
(72) Inventeur: BERGOGNE, Dominique, 43140 Saint Didier en Velay (FR)
(74) Mandataire: Cabinet Beaumont

(56) Documents cités:
- EP-A1- 2 824 835
- US-A- 5 216 294
- US-A1- 2008 290 911
- US-A1- 2011 012 542

## Description

### Domaine

La présente description concerne de façon générale les systèmes électroniques et, plus particulièrement, un régulateur de tension destiné à équiper de tels systèmes. La présente description concerne plus précisément un circuit de commande d'un transistor de puissance à grille.

### Exposé de l'art antérieur

Dans la quasi-totalité des systèmes électroniques, on utilise des circuits régulant une tension d'alimentation de divers composants et circuits du système.

On connait en particulier des régulateurs, dits "shunt", qui utilisent un composant de puissance, généralement un transistor MOS relié à la charge à alimenter avec une tension régulée. Ces régulateurs sont par exemple utilisés pour réguler la tension de charge d'une batterie, par exemple, une batterie de véhicule ou des batteries utilisées dans des installations photovoltaïques.

De plus, la commande des transistors de puissance fait appel à un circuit de commande ou de pilotage (driver) appliquant un signal de commande sur sa grille. Aujourd'hui, ce circuit de commande requiert une tension d'alimentation régulée, ce qui nécessite un circuit de régulation supplémentaire.

Plus généralement, lorsqu'un transistor de puissance est utilisé dans un système électronique, la commande de ce transistor requiert généralement une tension régulée pour des raisons de précision du signal appliqué sur sa grille.

Il existe un besoin d'améliorer les drivers pour transistors de puissance à grille.

Le document US 5216294 décrit un étage de sortie de données à base de transistors à effet de champ.

Le document Européen 2824835 décrit un circuit de commande d'un transistor à effet de champs, comprenant deux transistors en série dont les grilles respectives reçoivent un même signal de commande.

### Résumé

Un mode de réalisation pallie tout ou partie des inconvénients des circuits de commande usuels pour transistor de puissance.

Un mode de réalisation propose une solution moins encombrante.

Un mode de réalisation propose une solution particulièrement adaptée à une commande par modulation de largeur d'impulsion d'un étage de sortie du circuit de commande.

Ainsi, un mode de réalisation prévoit un dispositif de commande d'un premier transistor à grille de commande selon la revendication 1.

D'autres modes de réalisations sont prévus selon les revendications dépendantes.

Un mode de réalisation prévoit un procédé de commande selon la revendication 10.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est un schéma-bloc simplifié et partiel d'un exemple usuel d'un dispositif d'alimentation et de commande d'un transistor de puissance à grille ;
la figure 2 est un schéma-bloc simplifié et partiel d'un mode de réalisation d'un dispositif d'alimentation et de commande d'un transistor de puissance à grille ;
la figure 3 est un schéma-bloc d'un mode de réalisation d'un circuit de commande du dispositif de la figure 2 ;
la figure 4 est un schéma électrique plus détaillé d'un mode de réalisation du circuit de commande de la figure 3 ; et
la figure 5 illustre, sous forme de chronogrammes, le fonctionnement du circuit de la figure 4.

### Description détaillée

Par souci de clarté, seuls les éléments qui sont utiles à la compréhension des modes de réalisation décrits ont été représentés et seront détaillés. En particulier, la réalisation du transistor de puissance lui-même, commandé par le circuit décrit, n'a pas été détaillée, les modes de réalisation décrits étant compatibles avec les technologies usuelles de transistors de puissance. De plus, les applications du régulateur shunt comportant le circuit de commande décrit n'ont pas été détaillées, les modes de réalisation décrits étant, là encore, compatibles avec les applications usuelles de tels circuits de commande.

Il est à noter que, sur les figures, les éléments structurels et/ou fonctionnels communs aux différents modes de réalisation peuvent présenter les mêmes références et peuvent disposer de propriétés structurelles, dimensionnelles et matérielles identiques.

Sauf précision contraire, les expressions "approximativement", "sensiblement" et "de l'ordre de" signifient à 10 % près, de préférence à 5 % près.

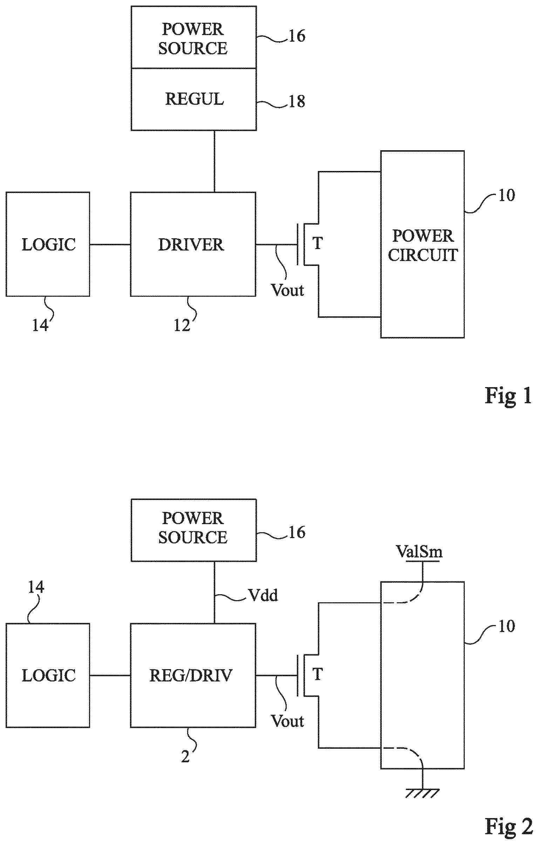

La figure 1 est un schéma-bloc simplifié et partiel d'un exemple usuel d'un dispositif d'alimentation et de commande d'un transistor de puissance à grille T, intégrant une fonction de régulation de tension.

Le transistor T est connecté à un circuit de puissance 10 (POWER CIRCUIT).

La grille du transistor T reçoit une tension Vout de commande d'un circuit de commande 12 (DRIVER). Dans les applications visées, le circuit de commande 12 reçoit une consigne d'un circuit logique 14 (LOGIC), typiquement un circuit générant des signaux en modulation de largeur d'impulsion en fonction des besoins du circuit de puissance. Le circuit 12 est alimenté à partir d'une source d'énergie 16 (POWER SOURCE). Dans l'exemple de la figure 1, l'énergie (tension ou courant) fournie par la source 16 doit être régulée (régulateur 18 - REGUL) avant d'être fournie au circuit de commande.

Le besoin d'utiliser des circuits distincts engendre de nombreux inconvénients, parmi lesquels un nombre accru de composants impliquant un risque accru de problèmes de fiabilité, un encombrement plus important, une influence supplémentaire des tolérances de fabrication, le besoin d'intervenir sur la source d'énergie pour la réguler, etc.

Les inventeurs prévoient de tirer profit de la structure interne du circuit de commande et plus particulièrement de son étage de sortie pour inclure une fonction de régulation dans le circuit de commande lui-même.

La figure 2 est un schéma-bloc simplifié et partiel d'un mode de réalisation d'un dispositif d'alimentation et de commande d'un transistor de puissance à grille.

Ce dispositif commande un transistor de puissance T relié à un circuit de puissance.

Selon le mode de réalisation de la figure 2, un circuit de commande ou driver 2 (REGDRIV) intègre avantageusement une fonction de régulation d'une tension ou d'un courant reçu d'une source d'énergie 16. La source d'énergie 16 n'a ici pas besoin d'être associée à un régulateur en amont du circuit 2. Le circuit 2 reçoit également une ou plusieurs consignes d'un circuit logique 14 (LOGIC), typiquement un circuit générant des signaux en modulation de largeur d'impulsion en fonction des besoins du circuit de puissance 10. En pratique, le circuit 14 obtient ces informations par des mesures (non représentées) d'informations au niveau du circuit de puissance. Le circuit 2 fournit une tension de grille Vout au transistor T.

Parmi les contraintes dont se sont aperçus les inventeurs pour la réalisation du circuit de commande 2, on note:
- le besoin d'une commande précise de la grille du transistor T qui conditionne le fonctionnement du circuit de puissance.
- le besoin de rester compatible avec une commande par modulation de largeur d'impulsions.

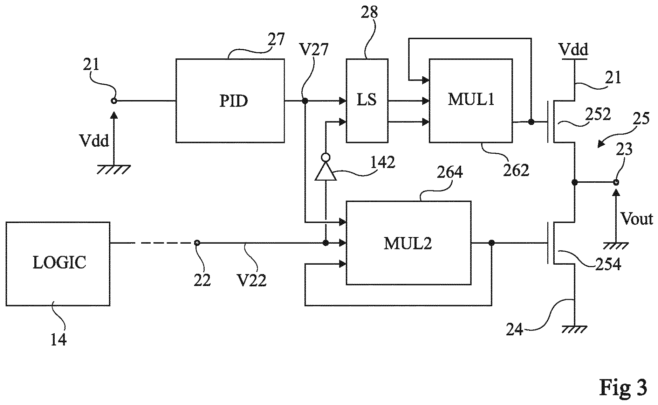

La figure 3 représente, sous forme de blocs, un mode de réalisation du circuit de commande 2 du dispositif de la figure 2.

Le circuit 2 comporte une borne 21 d'application d'une tension Vdd à réguler. Cette tension Vdd provient, par exemple, de la source d'énergie 16 de la figure 2. Le circuit 2 comporte également une borne d'entrée 22 destinée à recevoir un signal logique de commande du circuit 14, une borne 23 de sortie fournissant la tension Vout, et une borne 24 de raccordement à un potentiel de référence, par exemple la masse.

Un étage de sortie 25 du circuit 2 comporte deux transistors MOS 252 et 254 montés en série entre les bornes 21 et 24, le point milieu de cette association en série définissant la borne 23.

Les transistors 252 et 254 sont commandés en fonction du signal de consigne V22, comportant un train d'impulsions, fourni par le bloc logique 14. Ils sont commandés de façon à ne pas conduire simultanément et leurs périodes respectives de conduction permettent de contrôler la tension Vout appliquée à la grille du transistor T.

Selon les modes de réalisation décrits, l'un des transistors est commandé en tout ou rien (régime linéaire dans la zone ohmique à faible tension drain-source Vds) pendant que l'autre est utilisé en source de courant commandable (régime de saturation dans une zone à tension drain-source Vds élevée, proche de la tension Vdd). Pour simplifier, on dira par la suite que le transistor est passant quand il fonctionne en régime linéaire (commutateur), sachant qu'il est en fait également conducteur (à moindre mesure) quand il est en mode de saturation.

Quand le transistor 252 est passant, le transistor 254 est commandé en fonction d'une tension d'erreur V27 représentative de la variation de la tension Vdd par rapport à une valeur nominale. Quand le transistor 254 est passant, c'est au tour du transistor 252 d'être commandé en fonction de la tension d'erreur V27 représentative de la variation de la tension Vdd par rapport à sa valeur nominale. Ainsi, d'une part, la largeur des impulsions, fonction de la consigne fournie par le bloc 14, procure la commande habituelle, mais de plus, la variation du courant dans chacun des transistors pendant que l'autre est passant régule l'amplitude des impulsions en fonction d'éventuelles variations de la tension Vdd. Cela revient, indirectement, à réguler la tension d'alimentation Vdd. Le transistor 252 ou 254 qui fonctionne en source de courant joue en quelque sorte le rôle de régulateur shunt dans le circuit de commande 2.

La commande de chaque transistor 252, 254 provient d'un circuit ou multiplexeur 262 (MUL1), respectivement 264 (MUL2), réalisant une fonction de sélection entre deux signaux parmi un signal numérique V22, ou son inverse (inverseur 142) pour le transistor 252, fourni par le circuit logique 14, et un signal analogique V27 représentatif de la tension d'alimentation continue Vdd appliquée aux bornes de l'association en série des transistors 252 et 254. De préférence mais de façon optionnelle, le signal V27 est fourni par un régulateur PID 27 (Proportional-Integral-Differential). Chaque circuit 262, 264, est commandé par un signal numérique représentatif de l'état (bloqué ou passant) du transistor concerné 252 ou 254 détectant ses périodes de conduction à partir de sa grille. Pour le demi-étage haut (le transistor 252), la tension V27 et l'inverse de la tension V22 sont fournies par un circuit décaleur de niveau 28 (LS).

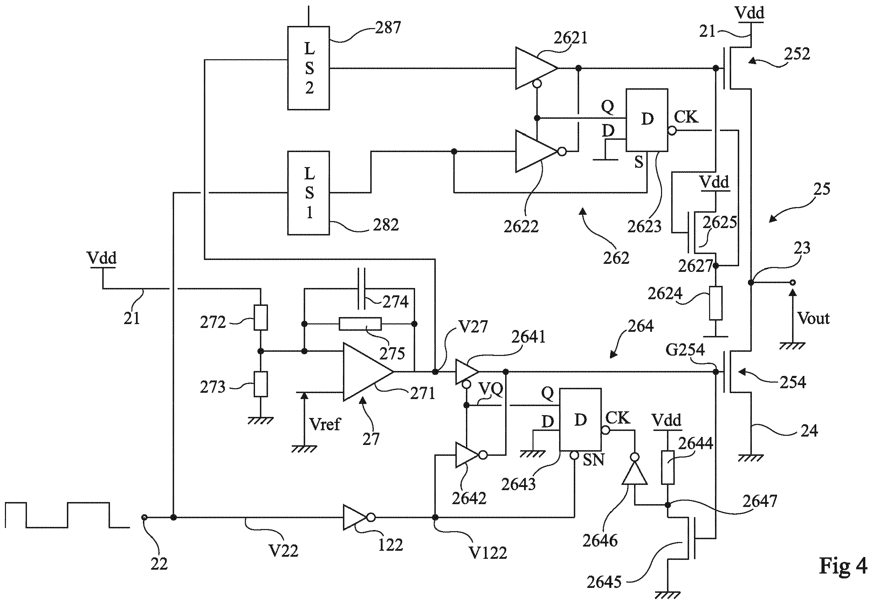

La figure 4 est un schéma électrique plus détaillé du circuit de la figure 2 illustrant un exemple de réalisation.

Le régulateur PID 27 comporte un amplificateur opérationnel 271 dont une première entrée reçoit une tension de référence Vref et dont une seconde entrée reçoit, par l'intermédiaire d'un pont résistif diviseur de tension (résistances R272 et R273 en série entre la borne 21 et la masse), une information proportionnelle à la tension Vdd. La sortie de l'amplificateur 271 est reliée à son entrée (point milieu de l'association en série des résistances 272 et 273) par une cellule RC formée d'un condensateur 274 et d'une résistance 275, intégrant la différence de tension entre les entrées de l'amplificateur. Les valeurs de la tension Vref et des résistances R271 et R272 sont choisies en fonction de la valeur nominale de la tension Vdd.

Côté demi-étage bas, le multiplexeur 264 comporte un interrupteur analogique 2641 entre la sortie de l'amplificateur 271 et la grille du transistor 254 et un inverseur logique 2642 à trois états entre la borne 22 et la grille du transistor 254. Dans l'exemple de la figure 4, un inverseur 122 est en fait intercalé entre la borne 22 et l'entrée de l'inverseur 2642. L'interrupteur 2641 et l'inverseur 2642 présentent une sortie en haute impédance lorsqu'ils sont désactivés. L'interrupteur 2642 et l'inverseur 2641 sont activés, respectivement par un signal prélevé sur la sortie directe (Q) d'une bascule 2643 de type D, et par l'inverse de ce signal. L'entrée D de la bascule 2643 est connectée à la masse. L'entrée SN de mise à un (set) inversée de la bascule 2643 est reliée en sortie de l'inverseur 122. L'entrée d'horloge CK de la bascule 2643 reçoit une indication logique de l'état du transistor 254. Par exemple, l'entrée d'horloge CK inversée (active sur front descendant) est reliée, par l'intermédiaire d'un inverseur 2646, au point milieu 2647 d'une association en série d'une résistance 2644 et d'un transistor 2645 à laquelle est appliquée la tension Vdd. La grille du transistor 2645 est connectée à la grille du transistor 254. Ce montage forme un détecteur du changement de régime du transistor 254 de linéaire (tension de grille nettement supérieure à la tension de seuil Vth du transistor - fonctionnement passant) à saturation (tension de grille proche de la tension seuil Vth du transistor-fonctionnement en source de courant).

Une structure similaire est présente coté demi-étage haut, aux différences près que les signaux V22 et V27 sont respectivement appliqués par l'intermédiaire de circuits décaleurs de niveau 282 (LS1) et 287 (LS2) et que l'indication logique de l'état du transistor est fournie par un circuit légèrement différent. Ainsi, le multiplexeur 262 comporte un interrupteur analogique 2621 entre la sortie du circuit décaleur de niveau 287 (dont l'entrée est reliée en sortie de l'amplificateur 271) et la grille du transistor 252 et un inverseur logique 2622 à trois états entre la sortie du circuit décaleur de niveau 282 et la grille du transistor 252. Par rapport au demi-étage bas, le signal V22 n'est ici pas inversé. L'interrupteur 2621 et l'inverseur 2622 présentent une sortie en haute impédance lorsqu'ils sont désactivés. L'interrupteur 2622 et l'inverseur 2621 sont activés, respectivement par un signal prélevé sur la sortie directe (Q) d'une bascule 2623 de type D, et par l'inverse de ce signal. L'entrée D de la bascule 2623 est connectée au niveau logique bas (0). L'entrée S de mise à un (set) de la bascule 2623 est reliée en sortie du décaleur de niveau 282. L'entrée d'horloge CK de la bascule 2623 reçoit une indication logique de l'état du transistor 252. Par exemple, l'entrée d'horloge CK inversée (active sur front descendant) est reliée au point milieu 2627 d'une association en série d'une résistance 2624 et d'un transistor 2625 à laquelle est appliquée la tension Vdd. La grille du transistor 2624 est connectée à la grille du transistor 252. Ce montage forme un détecteur du changement de régime du transistor 252 de linéaire (tension de grille nettement supérieure à la tension de seuil Vth du transistor-fonctionnement passant) à saturation (tension de grille proche de la tension seuil Vth du transistor - fonctionnement en source de courant). Côté demi-étage haut, le potentiel de référence (niveau bas) des circuits 2621, 2622, 2623 et appliqué à la résistance 2624 est une masse locale, décalée par les circuits décaleurs de niveau par rapport à la masse du demi-étage bas.

Le fonctionnement du circuit 2 et, plus particulièrement des multiplexeurs 262 et 264 est le suivant. Pour simplifier, on néglige les chutes de tension dans les transistors de sortie des circuits 2641 et 2642 ainsi que les chutes de tension dans les étages de sortie des portes logiques et inverseurs.

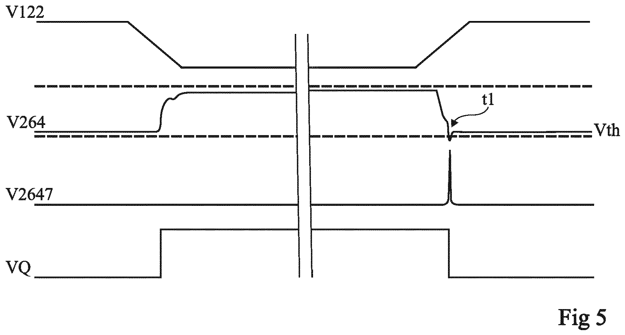

La figure 5 illustre le fonctionnement du circuit 262, sous forme de chronogrammes représentant des exemples d'allures des signaux V122 de commande, V264 appliqué sur la grille du transistor 254, V2647 de sortie du comparateur (résistance 2644 - transistor 2645) de la tension de grille du transistor 254 par rapport à son seuil Vth, et VQ de la sortie Q de la bascule 2643.

On suppose un état initial dans lequel le signal V122 est à l'état haut (signal V22 de commande à l'état bas) et la sortie Q de la bascule 2643 est à l'état bas. L'amplificateur analogique 2641 est alors actif. Le transistor 254 est alors en saturation et sa résistance drain-source est fonction de la tension d'erreur V27 transférée par l'amplificateur analogique 2641. La tension V254 est alors proche de la tension seuil Vth (non représentée). La sortie du circuit 2642 est en haute impédance afin de ne pas perturber la correction. Le signal V2647 est à l'état bas.

Lorsque le signal V122 commute à l'état bas (signal V22 commute à l'état haut), l'entrée SN de mise à un inversée de la bascule 2643 reçoit un front descendant, ce qui provoque la mise à un de la sortie Q. Cela inverse l'activation des amplificateurs 2641 et inverseur 2642. Ainsi, la grille G254 du transistor 254 reçoit l'état de sortie de l'inverseur 2642 qui se trouve à l'état haut (double inversion de l'état du signal V22). Le transistor 254 bascule alors en régime linéaire (fortement passant). L'amplificateur 2641 est désactivé (sortie en haute impédance). L'état du signal V2647 n'est pas modifié.

Lorsque le signal V22 commute de nouveau à l'état haut, le signal V264 descend vers un niveau bas sous l'effet de la commutation de la sortie de l'inverseur 2642. Quand la décharge de la grille G254 est telle qu'elle passe en dessous du seuil Vth (instant t1) et que le transistor 254 se bloque, cela est détecté par le transistor 2645 qui se bloque. Le signal V2647 commute alors vers un niveau haut (proche de la tension Vdd) . Cela provoque un front descendant (inversion par l'inverseur 2646 sur l'entrée d'horloge inversée de la bascule 2643) et, par conséquent, la prise en compte sur la sortie Q de l'état présent sur l'entrée D (le 0 logique) . Le signal VQ passe donc à l'état bas. Cela provoque l'inversion d'activation entre l'amplificateur 2641 et l'inverseur 2642. L'activation de l'amplificateur 2641 rend immédiatement de nouveau conducteur le transistor 254 en régime de saturation. Il en découle une commutation du transistor 2645 et le signal V2647 revient à l'état bas. Le transistor 254 fonctionne, jusqu'à la commutation suivante.

Le circuit est alors en source de courant et régule le niveau de la tension Vout en fonction d'éventuelles variations de la tension Vdd. Cet état se maintien jusqu'à la commutation suivante du signal V22.

Un fonctionnement similaire s'opère côté multiplexeur 262 et se déduit du fonctionnement décrit ci-dessus, à ceci près, qu'en raison de l'inversion des signaux de commande par rapport au multiplexeur 264, les périodes pendant lesquelles le transistor 252 est passant sont inversées par rapport à celles du transistor 254.

Ainsi, quand le transistor 252 est passant, le niveau de la tension Vout est ajusté par le transistor 254 en fonction d'éventuelles variations de la tension Vdd et, quand le transistor 254 est passant, le niveau de la tension Vdd est ajusté, par le transistor 252, en fonction d'éventuelles variations de la tension Vdd.

Un avantage des modes de réalisation décrits est que la régulation de la tension du circuit de commande est effectuée par le circuit lui-même. On économise ainsi l'utilisation de transistors dédiés à la régulation contrairement au cas usuel de la figure 1.

Un autre avantage est que le circuit ne requiert pas de modification des signaux de commande fournis par le circuit 14.

Divers modes de réalisation ont été décrits. Diverses variantes et modifications apparaîtront à l'homme de l'art. En particulier, bien que les modes de réalisation aient été décrits en relation avec la commande d'un transistor MOS de puissance, ils s'appliquent plus généralement à la commande de tout transistor à grille de commande, par exemple, un transistor HEMT, un transistor MOSFET, un transistor IGBT, etc. Par ailleurs, la mise en oeuvre pratique des modes de réalisation qui ont été décrits est à la portée de l'homme de métier à partir des indications fonctionnelles données ci-dessus.

## Revendications

1. Dispositif de commande d'un premier transistor (T) à grille de commande, comportant :
un deuxième transistor (252) et un troisième transistor (254) en série entre une première (21) et une deuxième (24) bornes d'application d'une tension d'alimentation (Vdd), le point milieu (23) de cette association en série étant destiné à être connecté à la grille du premier transistor ;
une borne (22) d'application d'un signal numérique de commande (V22) ; **caractérisé en ce qu'**il comporte en outre un circuit (27) de génération d'un signal analogique (V27) en fonction de variations de la tension d'alimentation ; et
pour chacun des deuxième et troisième transistors, un circuit (262 ; 264) de sélection entre ledit signal numérique et ledit signal analogique, l'un des deuxième et troisième transistors étant commandé en régime linéaire à partir dudit signal numérique tandis que l'autre est commandé en régime de saturation à partir dudit signal analogique.

2. Dispositif selon la revendication 1, dans lequel la sélection entre le signal numérique et le signal analogique est effectuée sur la base d'un signal représentatif dudit signal numérique (V22).

3. Dispositif selon la revendication 1 ou 2, dans lequel celui des deuxième (252) et troisième (254) transistors qui est commandé en fonction du signal numérique (V22) est commandé en régime linéaire tandis que l'autre, commandé en fonction du signal analogique (V27), est commandé en régime de saturation.

4. Dispositif selon l'une quelconque des revendications 1 à 3, dans lequel chaque circuit de sélection (262 ; 264) comporte un interrupteur analogique (2621 ; 2641) dont une entrée reçoit le signal analogique et un inverseur numérique (2622 ; 2642) dont une entrée reçoit le signal numérique (V22), les sorties de l'interrupteur et de l'inverseur étant reliées à la grille du transistor concerné.

5. Dispositif selon la revendication 4, dans lequel l'interrupteur et l'inverseur (2621, 2622 ; 2641, 2642) possèdent un état de sortie en haute impédance.

6. Dispositif selon l'une quelconque des revendications 1 à 5, comportant en outre des circuits (282, 287) décaleurs de niveau entre les circuits (14, 27) de génération des signaux numérique et analogique et le circuit de sélection affecté à l'un (252) des deuxième et troisième transistors.

7. Dispositif selon l'une quelconque des revendications 1 à 6, dans lequel le circuit (27) de génération du signal analogique est un régulateur PID.

8. Dispositif selon l'une quelconque des revendications 1 à 7, comportant une entrée (22) destinée à être reliée à un circuit (14) de génération du signal numérique (V22), fournissant un train d'impulsions de largeur variable.

9. Dispositif selon l'une quelconque des revendications 1 à 8, dans lequel les transistors (T, 252, 254) sont des transistors MOS.

10. Procédé de commande d'un premier transistor (T) à grille de commande, à partir d'un deuxième transistor (252) et d'un troisième transistor (254) en série entre une première et une deuxième bornes d'application d'une tension d'alimentation, et dont le point milieu (23) est connecté à la grille du premier transistor, et comprenant pour chacun des deuxième et troisième transistors un circuit de sélection, entre ledit signal numérique et un signal analogique généré en fonction des variations de la tension d'alimentation, dans lequel l'un des deuxième et troisième transistors est commandé en régime linéaire à partir dudit signal numérique tandis que l'autre est commandé en régime de saturation à partir dudit signal analogique.

## Patentansprüche

1. Vorrichtung zum Steuern eines ersten Steuergatetransistors (T), die Folgendes aufweist:
einen zweiten Transistor (252) und einen dritten Transistor (254), die in Reihe zwischen einem ersten Anschluss (21) und einem zweiten Anschluss (24) zum Anlegen einer Leistungsversorgungsspannung (Vdd) angeschlossen sind, wobei der Verbindungspunkt (23) von diesen Transistoren mit dem Gate des ersten Transistors verbunden werden soll;
einen Anschluss (22) zum Anlegen eines digitalen Steuersignals (V22); **dadurch gekennzeichnet, dass** sie weiter eine Schaltung (27) aufweist, um ein analoges Signal (V27) gemäß Variationen der Leistungsversorgungsspannung zu erzeugen; und
wobei für jeden der zweiten und dritten Transistoren eine Schaltung (262; 264) zur Auswahl zwischen dem digitalen Signal und dem analogen Signal vorgesehen ist, wobei einer der zweiten und dritten Transistoren in einem linearen Zustand von dem digitalen Signal gesteuert wird, während der andere in einem gesättigten Zustand von dem analogen Signal gesteuert wird.

2. Vorrichtung nach Anspruch 1, wobei die Auswahl zwischen dem digitalen Signal und dem analogen Signal basierend auf einem Signal ausgeführt wird, welches das digitale Signal (V22) darstellt.

3. Vorrichtung nach Anspruch 1 oder 2, wobei jener von dem zweiten (252) und dritten (254) Transistoren, welcher gemäß dem digitalen Signal (V22) gesteuert wird, in einem linearen Zustand gesteuert wird, während der andere, der gemäß dem analogen Signal (V27) gesteuert wird, in einem gesättigten Zustand gesteuert wird.

4. Vorrichtung nach einem der Ansprüche 1 bis 3, wobei jede Auswahlschaltung (262; 264), die einen analogen Schalter (2621; 2641) aufweist, der einen Eingang hat, der das analoge Signal empfängt, und einen digitalen Inverter (2622; 2642) aufweist, der einen Eingang hat, der das digitale Signal (V22) empfängt, wobei die Ausgänge des Schalters und des Inverters mit dem Gate des angeschlossenen Transistors verbunden sind.

5. Vorrichtung nach Anspruch 4, wobei der Schalter und der Inverter (2621, 2622; 2641, 2642) einen Ausgangszustand mit hoher Impedanz haben.

6. Vorrichtung nach einem der Ansprüche 1 bis 5, die weiter Pegelverschiebungsschaltungen (282, 287) zwischen den Digital- und Analogsignalerzeugungsschaltungen (14, 27) und der Auswahlschaltung aufweisen, die dem einen (252) der zweiten und dritten Transistoren zugeordnet sind.

7. Vorrichtung nach einem der Ansprüche 1 bis 6, wobei die Analogsignalerzeugungsschaltung (27) ein PID-Regler ist.

8. Vorrichtung nach einem der Ansprüche 1 bis 7, die einen Eingang (22) aufweist, der vorgesehen ist, um mit einer Schaltung (14) zur Erzeugung des digitalen Signals (V22) gekoppelt zu werden, die eine Impulsabfolge von variabler Länge liefert.

9. Vorrichtung nach einem der Ansprüche 1 bis 8, wobei die Transistoren (T, 252, 254) MOS-Transistoren sind.

10. Verfahren zur Steuerung eines ersten Steuergatetransistors (T) von einem zweiten Transistor (252) und einem dritten Transistor (254) in Reihe zwischen einem ersten Anschluss und einem zweiten Anschluss zum Anlegen einer Versorgungsspannung, und wobei ihr Verbindungspunkt (23) mit dem Gate des ersten Transistors verbunden ist, und wobei für jeden der zweiten und dritten Transistoren eine Auswahlschaltung zwischen dem digitalen Signal und einem analogen Signal vorgesehen ist, welches als eine Funktion von Variationen der Versorgungsspannung erzeugt wird, und wobei einer der zweiten und dritten Transistoren in einem linearen Zustand von dem digitalen Signal gesteuert wird, während der andere in einem gesättigten Zustand von dem analogen Signal gesteuert wird.

## Claims

1. A device for controlling a first control gate transistor (T), comprising:
a second transistor (252) and a third transistor (254) series-connected between a first (21) and a second (24) terminals of application of a power supply voltage (Vdd), the junction point (23) of these transistors being intended to be connected to the gate of the first transistor;
a terminal (22) of application of a digital control signal (V22);
**characterized in that** it further includes a circuit (27) for generating an analog signal (V27) according to variations of the power supply voltage; and
for each of the second and third transistors, a circuit (262; 264) of selection between said digital signal and said analog signal, one of the second and third transistors being controlled in linear state from said digital signal whereas the other is controlled in saturated state from said analog signal.

2. The device of claim 1, wherein the selection between the digital signal and the analog signal is performed based on a signal representative of said digital signal (V22).

3. The device of claim 1 or 2, wherein that of the second (252) and third (254) transistors which is controlled according to the digital signal (V22) is controlled in linear state, while the other one, controlled according to the analog signal (V27), is controlled in saturated state.

4. The device of any of claims 1 to 3, wherein each selection circuit (262; 264) comprises an analog switch (2621; 2641) having an input receiving the analog signal and a digital inverter (2622; 2642) having an input receiving the digital signal (V22), the outputs of the switch and of the inverter being connected to the gate of the concerned transistor.

5. The device of claim 4, wherein the switch and the inverter (2621, 2622; 2641, 2642) have a high-impedance output state.

6. The device of any of claims 1 to 5, further comprising level-shifting circuits (282, 287) between the digital and analog signal generation circuits (14, 27) and the selection circuit assigned to one (252) of the second and third transistors.

7. The device of any of claims 1 to 6, wherein the analog signal generation circuit (27) is a PID regulator.

8. The device of any of claims 1 to 7, comprising an input (22) intended to be coupled to a the circuit (14) for generating the digital signal (V22) supplying a pulse train of variable length.

9. The device of any of claims 1 to 8, wherein the transistors (T, 252, 254) are MOS transistors.

10. A method of controlling a first control gate transistor (T), from a second transistor (252) and a third transistor (254) in series between a first and a second terminals of application of a supply voltage, and having their junction point (23) connected to the gate of the first transistor, and comprising for each of the second and third transistors a circuit of selection between the digital signal and an analog signal generated as a function of variations of the supply voltage, wherein one of the second and third transistors is controlled in linear state from said digital signal while the other one is controlled in saturated state from said analog signal.
